# EUROPEAN PATENT SPECIFICATION

(11) **EP 4 440 265 B1**
(45) Date of publication and mention of the grant of the patent: **21.10.2026**
(21) Application number: 22903400.4
(22) Date of filing: 05.12.2022
(51) Int. Cl.: H05K 7/20, B06B 1/06, H01Q 1/00, B06B 1/02, H01Q 1/02, H01Q 1/24

(54) **HEAT DISSIPATION ASSEMBLY AND CONTROL METHOD AND APPARATUS THEREFOR, AND HEAT DISSIPATOR**
WÄRMEABLEITUNGSANORDNUNG UND STEUERUNGSVERFAHREN UND VORRICHTUNG DAFÜR SOWIE WÄRMEABLEITER
ENSEMBLE DE DISSIPATION DE CHALEUR ET PROCÉDÉ DE COMMANDE ET APPAREIL ASSOCIÉ, ET DISSIPATEUR DE CHALEUR

(30) Priority: 08.12.2021 CN 202111493916
(43) Date of publication of application: 02.10.2024
(73) Proprietor: ZTE Corporation, Shenzhen, Guangdong 518057 (CN)
(72) Inventor: ZHANG, Xianming, Shenzhen, Guangdong 518057 (CN); LAN, Daiyan, Shenzhen, Guangdong 518057 (CN); ZHU, Yue, Shenzhen, Guangdong 518057 (CN); YANG, Jie, Shenzhen, Guangdong 518057 (CN); QIAN, Jie, Shenzhen, Guangdong 518057 (CN); DING, Wei, Shenzhen, Guangdong 518057 (CN)
(74) Representative: Savi, Massimiliano
(86) International application number: PCT/CN2022/136640
(87) International publication number: WO 2023/103978

(56) References cited:
- WO-A1-2014/007088
- CN-A- 101 978 172
- CN-A- 103 557 188
- CN-A- 103 747 656
- CN-A- 103 747 656
- CN-B- 106 930 964
- JP-A- 2005 024 229
- JP-A- 2009 089 504
- JP-A- 2009 089 504
- JP-A- 2013 193 030
- US-A1- 2007 205 694

## Description

### TECHNICAL FIELD

The present disclosure relates to the technical field of electronic heat dissipation, and more particularly, to a heat dissipation assembly and a control method therefor, an apparatus, a heat dissipator, and a communication device.

### BACKGROUND

Electronic products generate a large amount of heat during operation. To ensure product reliability, an effective heat dissipation method is needed to control temperature rise. With increasing demands for miniaturization and integration of electronic products, natural heat dissipation methods often cannot provide efficient temperature control. For example, for a Remote Radio Unit (RRU) or an Active Antenna Unit (AAU) of an outdoor communication base station, its mainstream heat dissipation method is natural heat dissipation (heat dissipation through heat dissipation fins). However, as power consumption of the RRU or the AAU increases continuously, a heat dissipation volume of the devices also needs to increase. Therefore, an active cooling method using forced air cooling is needed to reduce the size and weight of the device.

A piezoelectric vibration fan is suitable to forced air cooling of the RRU or the AAU of the outdoor communication base station due to its high reliability, low noise, low power consumption, high temperature resistance, and small installation space. However, for a piezoelectric vibration fan in the related art, after prolonged use, the amplitude of the vibration plate is significantly reduced, greatly weakening its heat dissipation capability.

CN103747656A relates to a heat-dissipating module used for devices equipped with heat-dissipating teeth. The heat-dissipating module comprises a fixing device and at least two vibrating units. Each vibrating unit comprises a piezoelectric element and a solid sheet. The piezoelectric element in each vibrating unit is connected with one end of the solid sheet in the same solid sheet. The fixing device is connected with the piezoelectric elements in the various vibrating units and is used for fixing the module.

JP2009089504A relates to a drive voltage frequency adjusting mechanism which comprises: a drive voltage applying means for applying a drive voltage of a prescribed frequency to a piezoelectric element; a drive current monitoring means for monitoring the drive current flowing in the piezoelectric element when the piezoelectric element is driven; and a control means for performing frequency control of the drive voltage to be applied to the piezoelectric element from the drive voltage applying means so as to maximize the drive current monitored by the drive current monitoring means.

CN106930964B relates to a piezoelectric fan inherent frequency measuring method and a piezoelectric fan. The method comprises the steps that a plurality of first frequencies are selected from the first frequency range of voltages input to the piezoelectric fan, the voltages of the multiple first frequencies are sequentially input to the piezoelectric fan correspondingly, and the input time lasts for the first preset time; the voltages of the multiple first frequencies are stopped being input to the piezoelectric fan correspondingly; the amplitude values of sampled signals of the voltages of the multiple first frequencies are obtained correspondingly within the time duration of the piezoelectric effect; and amplitude values, meeting the first preset condition, of the amplitude values of the sampled signals of the voltages of the multiple first frequencies are determined, and the first frequency of the voltage which corresponds to the amplitude value meeting the first preset condition is determined to be the real-time inherent frequency of the piezoelectric fan.

US20070205694A1 relates to heat removal systems, and more particularly to improved operation of a piezo fan device used for heat removal in an information handling system.

### SUMMARY

The invention is set out in the appended set of claims.

The present disclosure proposes a heat dissipation assembly and a control method therefor, an apparatus, a heat dissipator, and a communication device.

In accordance with a first aspect of the present disclosure, an embodiment provides a heat dissipation assembly, including a vibration plate unit and a drive unit, the vibration plate unit is provided with a vibration plate, and at least one piezoelectric sheet connected to the vibration plate, the drive unit is electrically connected to the vibration plate unit and is configured to: adjust, in response to meeting a trigger condition, a first driving frequency output to the piezoelectric sheet within a preset frequency range to obtain a plurality of corresponding first output currents, determine a target driving frequency based on the plurality of first output currents, and apply a driving voltage to the piezoelectric sheet based on the target driving frequency.

In accordance with a second aspect of the present disclosure, an embodiment provides a heat dissipator, including the heat dissipation assembly described in the embodiment of the first aspect of the present disclosure.

In accordance with a third aspect of the present disclosure, an embodiment provides a control method for a heat dissipation assembly, the heat dissipation assembly is provided with a vibration plate unit and a drive unit electrically connected to the vibration plate unit, and the vibration plate unit is provided with a vibration plate and at least one piezoelectric sheet connected to the vibration plate, the control method for a heat dissipation assembly includes: adjusting, in response to meeting a trigger condition, a first driving frequency output to the piezoelectric sheet within a preset frequency range to obtain a plurality of corresponding first output currents; determining a target driving frequency based on the plurality of first output currents; and applying a driving voltage to the piezoelectric sheet based on the target driving frequency.

In accordance with a fourth aspect of the present disclosure, an embodiment provides a communication device, including the heat dissipation assembly described in the embodiment of the first aspect of the present disclosure or the heat dissipator described in the embodiment of the second aspect of the present disclosure.

In accordance with a fifth aspect of the present disclosure, an embodiment provides an operation control apparatus, including at least one control processor and a memory configured to be communicatively connected to the at least one control processor, the memory stores instructions executable by the at least one control processor which, when executed by the at least one control processor, causes the at least one control processor to carry out the control method for a heat dissipation assembly described in the embodiment of the third aspect of the present disclosure.

In accordance with a sixth aspect of the present disclosure, an embodiment provides a computer-readable storage medium, storing computer-executable instructions which, when executed by a computer, causes the computer to carry out the control method for a heat dissipation assembly described in the embodiment of the third aspect of the present disclosure.

Additional features and advantages of the present disclosure will be set forth in the description which follows, and in part will be apparent from the description, or may be learned by the practice of the present disclosure. The objects and other advantages of the present disclosure can be realized and obtained by the structures particularly pointed out in the description, claims, and drawings.

### BRIEF DESCRIPTION OF DRAWINGS

The drawings are provided for a further understanding of the technical schemes of the present disclosure, and constitute a part of the description. The drawings and the embodiments of the present disclosure are used to illustrate the technical schemes of the present disclosure, and are not intended to limit the technical schemes of the present disclosure.

The present disclosure is further described below in conjunction with the accompanying drawings and embodiments.
FIG. 1 is a schematic structural diagram of a heat dissipation assembly according to an embodiment of the present disclosure;
FIG. 2 is a schematic structural diagram of a vibration plate unit with two piezoelectric sheets according to another embodiment of the present disclosure;
FIG. 3 is a schematic structural diagram of a vibration plate unit with a single piezoelectric sheet according to another embodiment of the present disclosure;
FIG. 4 is a schematic structural diagram of a heat dissipation assembly provided with 2N vibration plate units according to another embodiment of the present disclosure;
FIG. 5 is a schematic structural diagram of a heat dissipation assembly provided with 2N+1 vibration plate units according to another embodiment of the present disclosure;
FIG. 6 is a schematic structural diagram of a heat dissipation assembly with vibration plate units arranged in a two-dimensional array according to another embodiment of the present disclosure;
FIG. 7 is a schematic diagram of an array arrangement of vibration plate units along a first direction of a fastening structure according to another embodiment of the present disclosure;
FIG. 8 is a schematic diagram of an array arrangement of vibration plate units along a second direction of a fastening structure according to another embodiment of the present disclosure;
FIG. 9 is a schematic structural diagram of a heat dissipator according to an embodiment of the present disclosure;
FIG. 10 is a schematic structural diagram of a heat dissipator according to another embodiment of the present disclosure;
FIG. 11 is a flowchart of a control method for a heat dissipation assembly according to an embodiment of the present disclosure;
FIG. 12 is a flowchart of a control method for a heat dissipation assembly according to another embodiment of the present disclosure;
FIG. 13 is a flowchart of a control method for a heat dissipation assembly according to another embodiment of the present disclosure;
FIG. 14 is a flowchart of a control method for a heat dissipation assembly according to another embodiment of the present disclosure; and
FIG. 15 is a schematic structural diagram of an operation control apparatus according to an embodiment of the present disclosure.

### DETAILED DESCRIPTION

This section will describe in detail some embodiments of the present disclosure. Some embodiments of the present disclosure are shown in the accompanying drawings. The accompanying drawings are used to supplement the descriptions of the specification with graphics, such that people can understand each technical feature and the overall technical scheme of the present disclosure intuitively and vividly, but they shall not be understood as limiting the protection scope of the present disclosure.

In the descriptions of the present disclosure, "several" means one or more, "a plural of/multiple" means two or more, "greater than", "less than", "exceed" or variants thereof prior to a number or series of numbers is understood to not include the number adjacent to the term, and "above", "below", "within", and the like are understood to include the number. If used herein, the terms such as "first", "second", and the like are merely used for distinguishing technical features, and are not intended to indicate or imply relative importance, or implicitly point out the number of the indicated technical features, or implicitly point out the precedence order of the indicated technical features.

In the descriptions of the present disclosure, unless otherwise explicitly limited, terms such as "arrange", "install", and "connect" should be understood in a broad sense. Those having ordinary skills in the art can properly determine meanings of the terms in the present disclosure based on contents of the technical schemes.

A fan is a device that blows air. A commonly-used conventional rotary fan is limited duration application in outdoor scenes due to its unsatisfactory reliability, large noise, and high energy consumption caused by characteristics of a bearing and a blade. A piezoelectric vibration fan is applicable to forced air cooling of an RRU or an AAU of an outdoor communication base station due to its technical characteristics of high reliability, low noise, low power consumption, high temperature resistance, and small installation space.

In some embodiments, for practical application of piezoelectric vibration fans in heat dissipation by forced air cooling, piezoelectric vibration fans in the related art generally use a fixed-frequency driving mode. A fan vibration plate is fatigued after operating under long-term alternating stress. As a result, stiffness changes, and a natural frequency of the piezoelectric vibration fan shifts. In addition, in some specific environments, when foreign matter adheres to the fan vibration plate, the natural frequency of the system may also change, causing a fundamental frequency of the piezoelectric vibration fan to drift. Consequently, an amplitude is significantly reduced, and a heat dissipation capability is weakened. Typically, the natural frequency of the system changes due to accumulation of dust, grease, or catkins on the fan vibration plate. In this case, if the fixed-frequency driving mode is still used, a resonance phenomenon cannot occur. Consequently, an amplitude of the vibration plate becomes smaller, and a heat dissipation capability is weakened.

Embodiments of the present disclosure provide a heat dissipation assembly, a control method therefor, an apparatus, a heat dissipator, and a communication device, which can intelligently adjust a target driving frequency output to a piezoelectric sheet, to increase an amplitude of a vibration plate, and greatly improve a heat dissipation capability.

The embodiments of the present disclosure will be described blow in conjunction with the accompanying drawings.

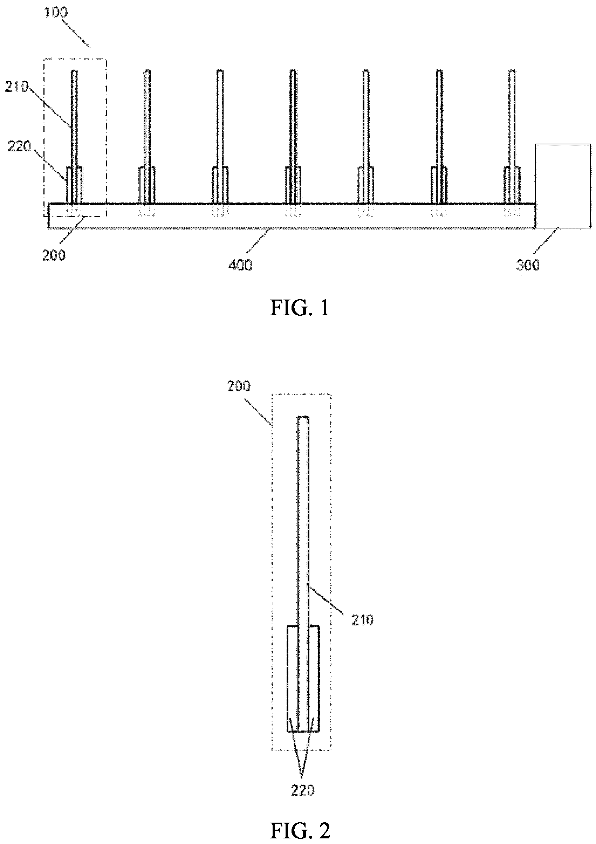

As shown in FIG. 1, the invention provides a heat dissipation assembly 100, including a vibration plate unit 200 and a drive unit 300. The vibration plate unit 200 is provided with a vibration plate 210, and at least one piezoelectric sheet 220 connected to the vibration plate 210. The drive unit 300 is electrically connected to the vibration plate unit 200, and the drive unit 300 is configured to: when a trigger condition is met, adjust a first driving frequency output to the piezoelectric sheet 220 within a preset frequency range to obtain a plurality of corresponding first output currents, determine a target driving frequency based on the plurality of first output currents, and apply a driving voltage to the piezoelectric sheet 220 based on the target driving frequency; and a fastening structure 400, the vibration plate unit 200 is connected to the fastening structure 400, and the vibration plate 210 has one end connected to the fastening structure 400 and the other end overhanging; a plurality of vibration plate units 200 are provided and arranged in an array along a first direction and a second direction of the fastening structure 400.

In this embodiment, the vibration plate unit 200 is formed by connecting the vibration plate 210 and the piezoelectric sheet 220. When a trigger condition is met, the drive unit 300 searches for a target driving frequency within a preset frequency range. A first driving frequency output to the piezoelectric sheet 220 is continually changed within the given preset frequency range to obtain a plurality of first output currents corresponding to the first driving frequency, and then the target driving frequency is determined. The drive unit 300 applies a driving voltage to the piezoelectric sheet 220 based on the target driving frequency. The drive unit 300 intelligently adjusts the target driving frequency output to the piezoelectric sheet 220, which can increase an amplitude of the vibration plate 210 to increase a wind speed of the heat dissipation assembly 100, and greatly improve a heat dissipation capability.

It should be noted that a resonance phenomenon is that when a frequency of an input driving voltage is equal to a natural frequency of the vibration plate unit 200, an overhanging end of the vibration plate 210 reaches a maximum amplitude. Different from a fixed-frequency driving mode used in some cases, the heat dissipation assembly 100 in this embodiment of the present disclosure uses a driving mode of automatic frequency training. The drive unit 300 may adjust the driving frequency based on a status of the heat dissipation assembly 100. When the natural frequency changes, the target driving frequency output to the piezoelectric sheet 220 can be intelligently adjusted to be consistent with the natural frequency, such that the vibration plate 210 always maintains a maximum amplitude under a resonance condition, which improves a heat dissipation effect and resolves drift of a fundamental frequency caused by the conventional natural-frequency driving mode.

It should be noted that the piezoelectric sheet 220 is made of a piezoelectric ceramic material, the vibration plate 210 is made of an elastic material, and the piezoelectric sheet 220 is bonded to the vibration plate 210 to form the vibration plate unit 200. The drive unit 300 applies an alternating voltage (a periodically changing direct current) to the piezoelectric sheet 220, and the piezoelectric sheet 220 performs periodic contraction based on an inverse piezoelectric effect of the piezoelectric material, which drives the vibration plate 210 to oscillate periodically, thereby driving fluid nearby to flow directionally.

In an embodiment, the drive unit 300 uses an intermittent direct current to drive the piezoelectric sheet 220. When the target driving frequency is close to the natural frequency of the vibration plate unit 200, the piezoelectric sheet 220 can drive the vibration plate 210 to vibrate to generate an objective directional wind speed, thereby ensuring a satisfactory heat dissipation effect.

It can be understood that the heat dissipation assembly 100 is a piezoelectric vibration fan. Since the heat dissipation assembly 100 generates a wind speed through oscillation of the vibration plate 210, heat exchange efficiency of a heat dissipator can be effectively improved. In addition, there are no bearing parts in the heat dissipation assembly 100, which helps improve reliability of the heat dissipation assembly 100, and is different from a conventional rotary fan used in some cases. The heat dissipation assembly 100 in this embodiment of the present disclosure effectively reduces system noise, resolves a problem of unsatisfactory heat dissipation capability of a conventional heat dissipation method for an outdoor communication device while ensuring reliability, and achieves a significant decrease in the size and weight of the communication device.

In the heat dissipation assembly 100, determining a target driving frequency based on the plurality of first output currents includes:
determining a current extremum based on the plurality of first output currents; and
determining a corresponding target driving frequency based on the current extremum.

In this embodiment, the drive unit 300 continually changes the first driving frequency within the given preset frequency range, records and stores corresponding first output currents at first driving frequencies, determines a current extremum (a maximum value or a minimum value of the currents) based on the plurality of obtained first output currents, a target driving frequency corresponding to the current extremum being a better frequency, and applies a driving voltage to the piezoelectric sheet 220 based on the target driving frequency.

It should be noted that it is found through experiments that within the given frequency range, the driving frequency corresponding to the current extremum leads to a maximum amplitude of the vibration plate 210 and a maximum wind speed of the heat dissipation assembly 100, thereby improving a heat dissipation effect. Therefore, the target driving frequency is a better frequency.

In the heat dissipation assembly 100, the trigger condition includes at least one of the following that:
the heat dissipation assembly 100 is started; or
a second output current of the drive unit 300 is detected when the heat dissipation assembly 100 operates continuously, and a difference between the second output current and the current extremum exceeds a preset difference range; or
a continuous operation time of the heat dissipation assembly 100 reaches a preset time period after the target driving frequency is determined each time.

In this embodiment, the trigger condition is added for the drive unit 300 to search for a better frequency. Only when the trigger condition is met, the drive unit 300 searches for the target driving frequency, which can ensure operation stability of the heat dissipation assembly 100. The trigger condition may be met in the following three cases:
1. The drive unit 300 is triggered once each time the heat dissipation assembly 100 is started.
2. When the heat dissipation assembly 100 operates continuously, the drive unit 300 regularly detects the second output current, and compares the second output current with the internally stored current extremum. When a difference between the detected second output current and the stored current extremum exceeds the specified preset difference range, the drive unit 300 is triggered to perform the action of searching for a better frequency.
3. When the heat dissipation assembly 100 operates continuously, based on the preset time period, the drive unit 300 is triggered to perform the action of searching for a better frequency each time one preset time period elapses, that is, triggered once when a continuous operation time reaches the preset time period after the target driving frequency is determined each time.

As shown in FIG. 1, the heat dissipation assembly 100 further includes a fastening structure 400. The vibration plate unit 200 is connected to the fastening structure 400, and the vibration plate 210 has one end connected to the fastening structure 400 and the other end overhanging.

In this embodiment, the fastening structure 400 provides a boundary fastening condition for the vibration plate unit 200. The vibration plate unit 200 may be fastened to the fastening structure 400 by injection molding or mechanical crimping, to ensure operation stability of the vibration plate 210.

It should be noted that the drive unit 300 may be independent of the vibration plate unit 200 and the fastening structure 400 such that the vibration plate unit 200, the fastening structure 400, and the drive unit 300 form a split heat dissipation assembly 100, or may be integrated into the fastening structure 400 such that the vibration plate unit 200, the fastening structure 400, and the drive unit 300 form an integrated heat dissipation assembly 100.

In the heat dissipation assembly 100, the piezoelectric sheet 220 is arranged at an end of the vibration plate 210 connected to the fastening structure 400. The vibration plate 210 can oscillate periodically as driven by the piezoelectric sheet 220, to generate a wind speed, thereby ensuring a satisfactory heat dissipation effect.

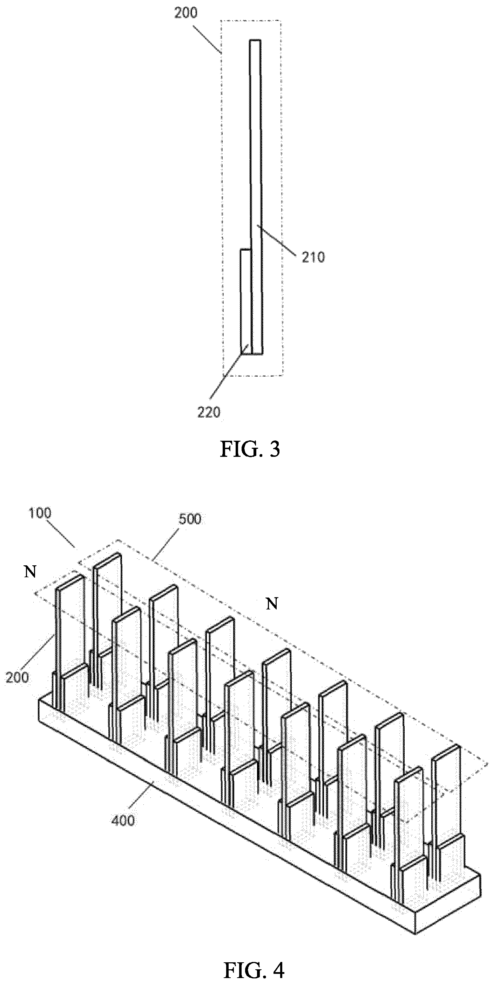

As shown in FIG. 2 and FIG. 3, in the heat dissipation assembly 100, one side of the vibration plate 210 is provided with the piezoelectric sheet 220, or two sides of the vibration plate 210 are both provided with the piezoelectric sheet 220.

As shown in FIG. 2 and FIG. 3, in this embodiment, the vibration plate unit 200 may be formed by connecting one piezoelectric sheet 220 to one side of the vibration plate 210, or may be formed by connecting one piezoelectric sheet 220 to each of the two sides of the vibration plate 210. When two piezoelectric sheets 220 are arranged on the two sides of the vibration plate 210, the vibration plate unit 200 can generate a greater driving force, to increase the wind speed of the heat dissipation assembly 100.

As shown in FIG. 4, in the heat dissipation assembly 100, 2N vibration plate units 200 are provided and divided into two vibration plate arrays 500 each including N vibration plate units 200, and the drive unit 300 is further configured to apply driving signals with opposite phases to the vibration plate units 200 located in different arrays respectively, where N≥1.

In this embodiment, when an even number (2N) of vibration plate units 200 are arranged, the 2N vibration plate units 200 may be divided into two vibration plate arrays 500 each including N vibration plate units 200. During driving, the drive unit 300 respectively applies driving signals with opposite phases to the vibration plate units 200 in different arrays. By controlling phase values of driving signals applied to different vibration plate units 200, symmetrical vibration can be formed to reduce overall vibration of the heat dissipation assembly 100, thereby reducing noise generated by resonance between the heat dissipation assembly 100 and a heat dissipator 600. It should be noted that in this embodiment of the present disclosure, a selection method for the N vibration plate units 200 in each array is not limited. For example, N adjacent vibration plate units 200 may be selected, or N vibration plate units 200 may be selected alternately.

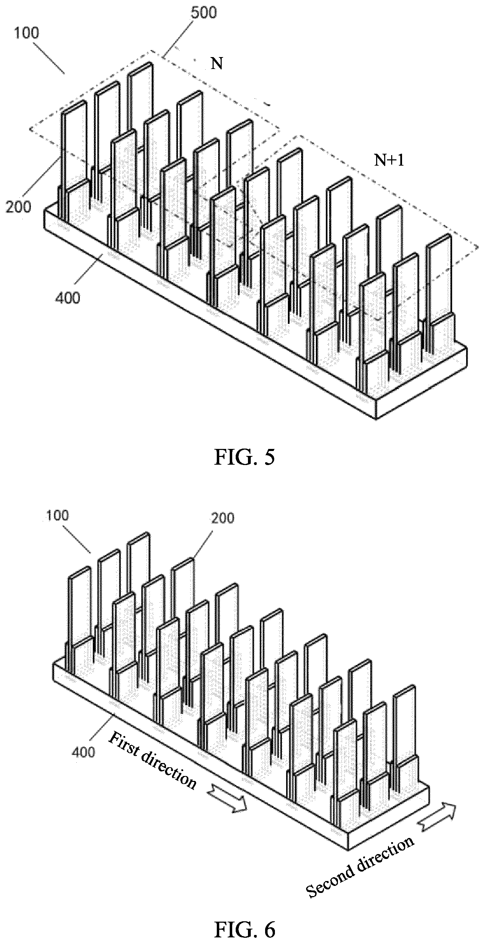

As shown in FIG. 5, in the heat dissipation assembly 100, 2N+1 vibration plate units 200 are provided and divided into two vibration plate arrays 500. The two vibration plate arrays 500 respectively include N+1 vibration plate units 200 and N vibration plate units 200, and the drive unit 300 is further configured to apply driving signals with opposite phases to vibration plate units 200 located in different arrays respectively, where N≥1.

In this embodiment, when an odd number (2N+1) of vibration plate units 200 are arranged, the 2N+1 vibration plate units 200 may be divided into two vibration plate arrays 500, with one array including include N+1 vibration plate units 200, and the other array including N vibration plate units 200. During operation, the drive unit 300 applies driving signals with opposite phases to the vibration plate units 200 in different arrays, respectively. By controlling phase values of driving signals applied to different vibration plate units 200, symmetrical vibration can be formed to reduce overall vibration of the heat dissipation assembly 100, thereby reducing noise generated by resonance between the heat dissipation assembly 100 and a heat dissipator 600.

It should be noted that a plurality of vibration plate units 200 are arranged. In this embodiment of the present disclosure, two forms, namely, an even number of vibration plate units 200 and an odd number of vibration plate units 200 are adopted. The vibration plate units 200 are divided into two arrays, and driving voltages with opposite phases are respectively applied thereto, which can greatly reduce operating noise.

It should be noted that the drive unit 300 adjusts a frequency during operation. In this embodiment of the present disclosure, the number of drive units 300 is not limited. For example, each vibration plate unit 200 may have one drive unit 300 configured, or a plurality of vibration plates 210 may share one drive unit 300, to form the heat dissipation assembly 100 of the present disclosure.

As shown in FIG. 6, in the heat dissipation assembly 100, a plurality of vibration plate units 200 are provided and arranged in an array along a first direction and a second direction of the fastening structure 400.

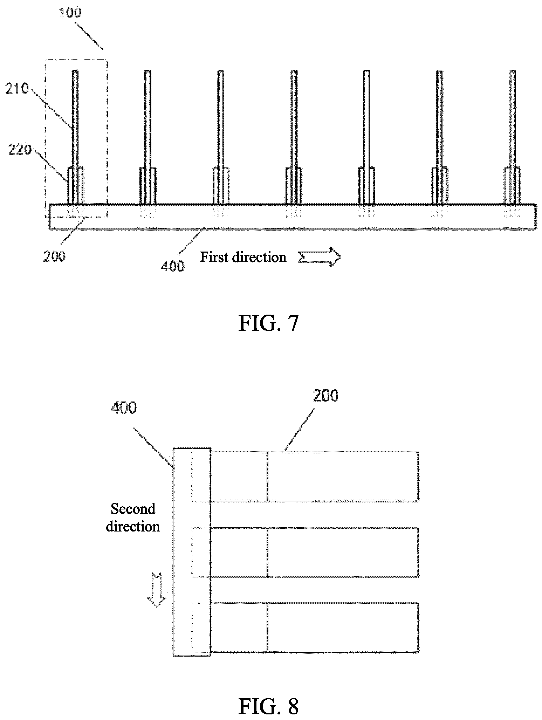

As shown in FIG. 6 to FIG. 8, in this embodiment, the heat dissipation assembly 100 includes a plurality of vibration plate units 200 arranged in an array. The vibration plate units 200 are arranged on the fastening structure 400 in an array including two direction dimensions. FIG. 7 is a schematic diagram of an array arrangement of the vibration plate units 200 along the first direction of the fastening structure 400. FIG. 8 is a schematic diagram of an array arrangement of the vibration plate units 200 along the second direction of the fastening structure 400. Through the array arrangement along the first direction and the second direction of the fastening structure 400, the plurality of vibration plate units 200 are arranged in a two-dimensional array structure on the fastening structure 400, to form the heat dissipation assembly 100 shown in FIG. 6, which can increase an air outlet area of the heat dissipation assembly 100, to help improve heat dissipation performance, and resolve a problem that a wind speed of a conventional piezoelectric vibration fans attenuates excessively quickly in heat dissipation fins.

An embodiment of a second aspect of the present disclosure provides a heat dissipator 600, including the heat dissipation assembly 100 in the foregoing embodiments.

As shown in FIG. 1, FIG. 9, and FIG. 10, the heat dissipator 600 provided in this embodiment is provided with the heat dissipation assembly 100. The heat dissipation assembly 100 includes a vibration plate unit 200 and a drive unit 300. The vibration plate unit 200 is formed by connecting a vibration plate 210 and a piezoelectric sheet 220. When a trigger condition is met, the drive unit 300 searches for a target driving frequency within a preset frequency range. A first driving frequency output to the piezoelectric sheet 220 is continually changed within the given preset frequency range to obtain a plurality of first output currents corresponding to the first driving frequency, and then the target driving frequency is determined. The drive unit 300 applies a driving voltage to the piezoelectric sheet 220 based on the target driving frequency. The drive unit 300 intelligently adjusts the target driving frequency output to the piezoelectric sheet 220, which can increase an amplitude of the vibration plate 210, increase a wind speed of the heat dissipation assembly 100, and greatly improve a heat dissipation capability.

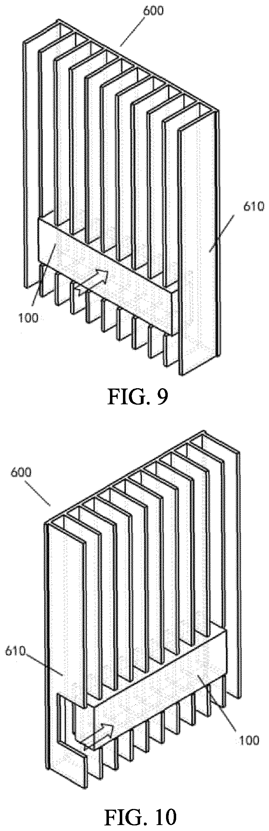

As shown in FIG. 9 and FIG. 10, the heat dissipator 600 is provided with a base 610, and the heat dissipation assembly 100 is mounted on the heat dissipator 600 along a normal direction of the base 610, or the heat dissipation assembly 100 is mounted on the heat dissipator 600 along a direction parallel to the base 610.

In this embodiment, the heat dissipator 600 is provided with a base 610, and the heat dissipation assembly 100 may be mounted and fastened on the heat dissipator 600 in two manners: perpendicular to the base 610 or parallel to the base 610. The two manners are described as follows.

Manner one: As shown in FIG. 9, the heat dissipation assembly 100 is mounted and fastened along the normal direction of the base 610, that is, mounted along a depth direction of the heat dissipator 600, which can be flexibly located at any height in the normal direction of the base 610, making it easy to install and having satisfactory stability and reliability.

Manner two: As shown in FIG. 10, the heat dissipation assembly 100 is mounted and fastened sideways along the direction parallel to the base 610, that is, located and mounted along a width direction of the heat dissipator 600, which facilitates installation and replacement of the heat dissipation assembly 100.

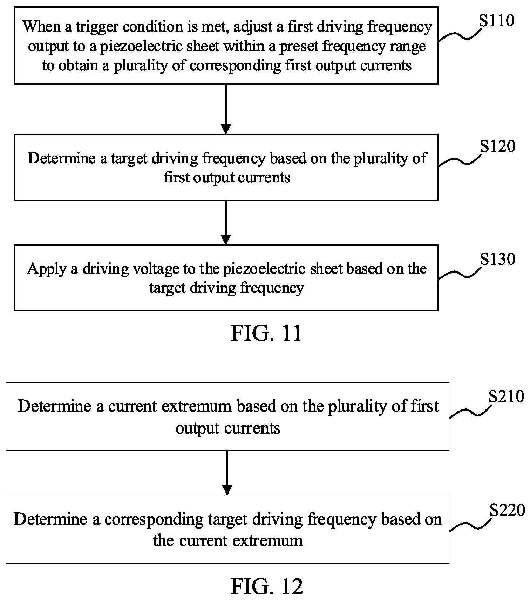

As shown in FIG. 1 and FIG. 11, an embodiment of a third aspect of the present disclosure provides a control method for a heat dissipation assembly. The heat dissipation assembly 100 is provided with a vibration plate unit 200 and a drive unit 300 electrically connected to the vibration plate unit 200, and the vibration plate unit 200 is provided with a vibration plate 210 and at least one piezoelectric sheet 220 connected to the vibration plate 210, and the heat dissipation assembly 100 is further provided with a fastening structure 400, the vibration plate unit 200 is connected to the fastening structure 400, and the vibration plate 210 has one end connected to the fastening structure 400 and the other end overhanging; a plurality of vibration plate units 200 are provided and arranged in an array along a first direction and a second direction of the fastening structure 400. The control method for a heat dissipation assembly includes the following steps S110 to S130.

At S110, when a trigger condition is met, a first driving frequency output to the piezoelectric sheet is adjusted within a preset frequency range to obtain a plurality of corresponding first output currents.

At S120, a target driving frequency is determined based on the plurality of first output currents.

At S130, a driving voltage is applied to the piezoelectric sheet based on the target driving frequency.

In this embodiment, the vibration plate unit 200 is formed by connecting the vibration plate 210 and the piezoelectric sheet 220. When a trigger condition is met, the drive unit 300 searches for a target driving frequency within a preset frequency range. A first driving frequency output to the piezoelectric sheet 220 is continually changed within the given preset frequency range to obtain a plurality of first output currents corresponding to the first driving frequency, and then the target driving frequency is determined. The drive unit 300 applies a driving voltage to the piezoelectric sheet 220 based on the target driving frequency. The drive unit 300 intelligently adjusts the target driving frequency output to the piezoelectric sheet 220, which can increase an amplitude of the vibration plate 210 to increase a wind speed of the heat dissipation assembly 100, and greatly improve a heat dissipation capability.

It should be noted that the drive unit 300 applies an alternating voltage (a periodically changing direct current) to the piezoelectric sheet 220, such that the piezoelectric sheet 220 drives the vibration plate 210 to oscillate periodically, thereby generating an air flow. In the control method for a heat dissipation assembly in this embodiment of the present disclosure, a driving mode of automatic frequency training is used. The drive unit 300 may be controlled to adjust the driving frequency based on a status of the heat dissipation assembly 100. When a natural frequency of the heat dissipation assembly 100 changes, the target driving frequency output to the piezoelectric sheet 220 can be intelligently adjusted to be close to the natural frequency, such that an amplitude of the vibration plate 210 is maximized as much as possible, which helps improve a heat dissipation effect and resolves drift of a fundamental frequency caused by a conventional fixed-frequency driving mode.

As shown in FIG. 12, in the control method for a heat dissipation assembly, determining a target driving frequency based on the plurality of first output currents at S120 includes the following steps S210 and S220:
At S210, a current extremum is determined based on the plurality of first output currents.
At S220, a corresponding target driving frequency is determined based on the current extremum.

In this embodiment, the drive unit 300 continually changes the first driving frequency f within the given preset frequency range, records and stores corresponding first output currents I₁ at first driving frequencies f, determines a current extremum I₀ (a maximum value or a minimum value of the currents) based on the plurality of obtained first output currents I₁, a target driving frequency f₀ corresponding to the current extremum I₀ being a better frequency, and applies a driving voltage to the piezoelectric sheet 220 based on the target driving frequency f₀.

In the control method for a heat dissipation assembly, the trigger condition includes at least one of the following that:
the heat dissipation assembly 100 is started; or
a second output current I₂ of the drive unit 300 is detected when the heat dissipation assembly 100 operates continuously, and a difference between the second output current I₂ and the current extremum I₀ exceeds a preset difference range; or
a continuous operation time of the heat dissipation assembly 100 reaches a preset time period after the target driving frequency f₀ is determined each time.

In this embodiment, the trigger condition is added for the drive unit 300 to search for a better frequency. Only when the trigger condition is met, the drive unit 300 searches for the target driving frequency f₀, which can ensure operation stability of the heat dissipation assembly 100. Conditions for triggering the search for a better frequency include: 1. The drive unit 300 is triggered once each time the heat dissipation assembly 100 is started. 2. When the heat dissipation assembly 100 operates continuously, the drive unit 300 regularly detects the second output current I₂, and compares the second output current I₂ with the internally stored current extremum I₀. When a difference between the detected second output current I₂ and the stored current extremum I₀ exceeds the specified preset difference range, the drive unit 300 is triggered to perform the action of searching for a better frequency. 3. When the heat dissipation assembly 100 operates continuously, based on the preset time period T, the drive unit 300 is triggered to perform the action of searching for a better frequency each time one preset time period T elapses, that is, triggered once when a continuous operation time reaches the preset time period T after the target driving frequency f₀ is determined each time.

Two embodiments of the control method for a heat dissipation assembly in the present disclosure are described below.

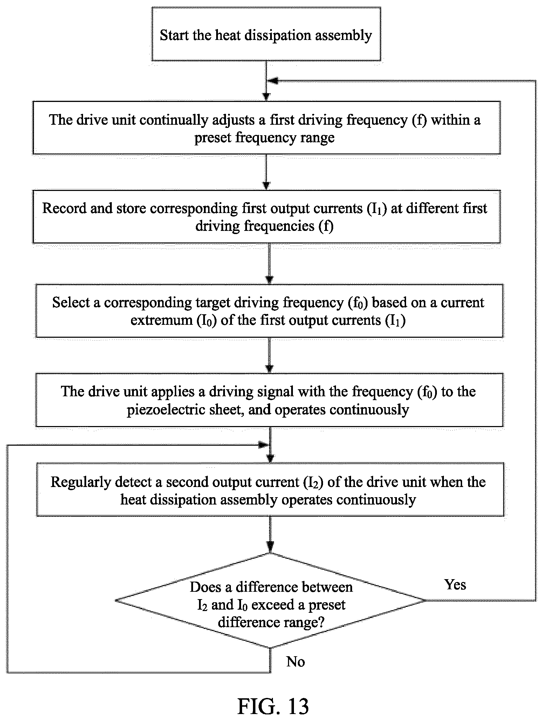

Embodiment one: As shown in FIG. 13, the heat dissipation assembly is started, and the drive unit continually adjusts a first driving frequency f within a preset frequency range, records and stores corresponding first output currents I₁ at different first driving frequencies f, and selects a corresponding target driving frequency f₀ based on a current extremum I₀ of the first output currents I₁. The drive unit applies a driving signal with the frequency f₀ to the piezoelectric sheet, operates continuously, regularly detects a second output current I₂ of the drive unit when the heat dissipation assembly operates continuously, and when a difference between the second output current I₂ and the stored current extremum I₀ exceeds a preset difference range, searches for a target driving frequency f₀ again.

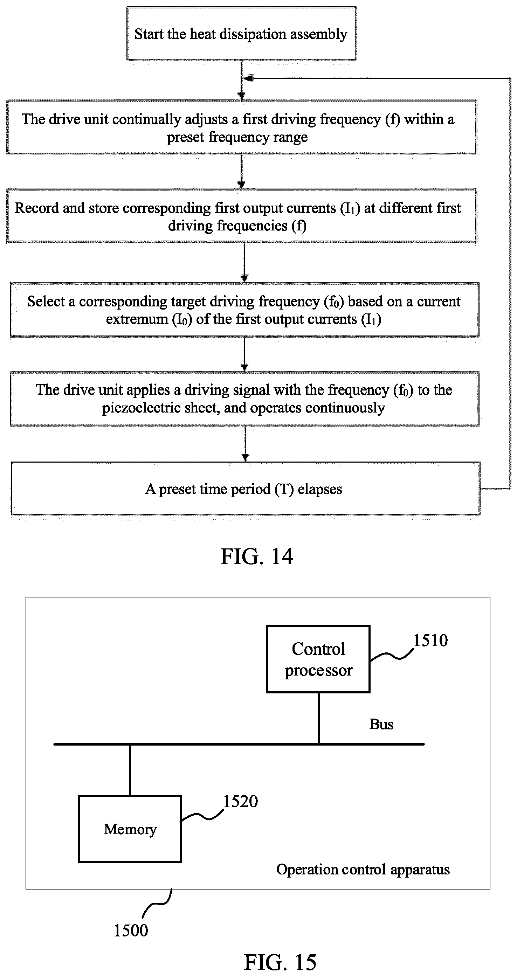

Embodiment two: As shown in FIG. 14, the heat dissipation assembly is started, and the drive unit continually adjusts a first driving frequency f within a preset frequency range, records and stores corresponding first output currents I₁ at different first driving frequencies f, and selects a corresponding target driving frequency f₀ based on a current extremum I₀ of the first output currents I₁. The drive unit applies a driving signal with the frequency f₀ to the piezoelectric sheet, operates continuously, and after a preset time period T elapses, searches for a target driving frequency f₀ again.

As shown in FIG. 4, in the control method for a heat dissipation assembly, 2N vibration plate units 200 are provided and divided into two vibration plate arrays 500 each including N vibration plate units 200, where N≥1. The control method for a heat dissipation assembly further includes:
applying driving signals with opposite phases to vibration plate units 200 located in different arrays, respectively.

In this embodiment, when an even number (2N) of vibration plate units 200 are arranged, the 2N vibration plate units 200 may be divided into two vibration plate arrays 500 each includes N vibration plate units 200. During driving, the drive unit 300 applies driving signals with opposite phases to vibration plate units 200 in different arrays, respectively. By controlling phase values of the driving signals of different vibration plate units 200, symmetrical vibration can be formed to reduce overall vibration of the heat dissipation assembly 100, thereby reducing noise generated by resonance between the heat dissipation assembly 100 and a heat dissipator 600.

As shown in FIG. 5, in the control method for a heat dissipation assembly, 2N+1 vibration plate units 200 are provided and divided into two vibration plate arrays 500, and the two vibration plate arrays 500 respectively include N+1 vibration plate units 200 and N vibration plate units 200, where N≥1. The control method for a heat dissipation assembly further includes:
applying driving signals with opposite phases to vibration plate units 200 located in different arrays, respectively.

In this embodiment, when an odd number (2N+1) of vibration plate units 200 are arranged, the 2N+1 vibration plate units 200 may be divided into two vibration plate arrays 500, with one array including include N+1 vibration plate units 200, and the other array including N vibration plate units 200. During operation, the drive unit 300 applies driving signals with opposite phases to vibration plate units 200 in different arrays, respectively. By controlling phase values of the driving signals of different vibration plate units 200, symmetrical vibration can be formed to reduce overall vibration of the heat dissipation assembly 100, thereby reducing noise generated by resonance between the heat dissipation assembly 100 and a heat dissipator 600.

It should be noted that a plurality of vibration plate units 200 are arranged. In this embodiment of the present disclosure, two forms, namely, an even number of vibration plate units 200 and an odd number of vibration plate units 200 are adopted. The vibration plate units 200 are divided into two arrays, and driving voltages with opposite phases are respectively applied thereto, that is, the vibration plate units 200 are driven in portions, which can greatly reduce operating noise.

An embodiment of a fourth aspect of the present disclosure provides a communication device, including the heat dissipation assembly 100 or the heat dissipator 600 in the foregoing embodiments.

The communication device provided in this embodiment includes the heat dissipation assembly 100 or the heat dissipator 600 in the foregoing embodiments. The heat dissipator 600 is provided with the heat dissipation assembly 100. The vibration plate unit 200 is formed by connecting a vibration plate 210 and a piezoelectric sheet 220. When a trigger condition is met, the drive unit 300 searches for a target driving frequency within a preset frequency range. A first driving frequency output to the piezoelectric sheet 220 is continually changed within the given preset frequency range to obtain a plurality of first output currents corresponding to the first driving frequency, and then the target driving frequency is determined. The drive unit 300 applies a driving voltage to the piezoelectric sheet 220 based on the target driving frequency. The drive unit 300 intelligently adjusts the target driving frequency output to the piezoelectric sheet 220, which can increase an amplitude of the vibration plate 210 to increase a wind speed of the heat dissipation assembly 100, and greatly improve a heat dissipation capability.

The communication device in this embodiment of the present disclosure may be an outdoor communication device with high reliability and noise requirements such as an AAU or an RRU, or may be an indoor communication device such as a Building Base Band Unit (BBU).

As shown in FIG. 15, an embodiment of a fifth aspect of the present disclosure provides an operation control apparatus 1500, including at least one control processor 1510 and a memory 1520 configured to be communicatively connected to the at least one control processor 1510. The memory 1520 stores instructions executable by the at least one control processor 1510 which, when executed by the at least one control processor 1510, causes the at least one control processor 1510 to carry out the control method for a heat dissipation assembly in the foregoing embodiments.

In the operation control apparatus provided in this embodiment, when a trigger condition is met, the drive unit 300 searches for a target driving frequency within a preset frequency range. A first driving frequency output to the piezoelectric sheet 220 is continually changed within the given preset frequency range to obtain a plurality of first output currents corresponding to the first driving frequency, and then the target driving frequency is determined. The drive unit 300 applies a driving voltage to the piezoelectric sheet 220 based on the target driving frequency. The drive unit 300 intelligently adjusts the target driving frequency output to the piezoelectric sheet 220, which can increase an amplitude of the vibration plate 210 to increase a wind speed of the heat dissipation assembly 100, and greatly improve a heat dissipation capability.

An embodiment of a sixth aspect of the present disclosure provides a computer-readable storage medium, storing computer-executable instructions which, when executed by a computer, causes the computer to implement the control method for a heat dissipation assembly in the foregoing embodiments.

In the computer-readable storage medium provided in this embodiment, when a trigger condition is met, the drive unit 300 searches for a target driving frequency within a preset frequency range. A first driving frequency output to the piezoelectric sheet 220 is continually changed within the given preset frequency range to obtain a plurality of first output currents corresponding to the first driving frequency, and then the target driving frequency is determined. The drive unit 300 applies a driving voltage to the piezoelectric sheet 220 based on the target driving frequency. The drive unit 300 intelligently adjusts the target driving frequency output to the piezoelectric sheet 220, which can increase an amplitude of the vibration plate 210 to increase a wind speed of the heat dissipation assembly 100, and greatly improve a heat dissipation capability.

The embodiments of the present disclosure include a heat dissipation assembly and a control method therefor, an apparatus, a heat dissipator, and a communication device. The heat dissipation assembly includes a vibration plate unit and a drive unit. The vibration plate unit is provided with a vibration plate and at least one piezoelectric sheet connected to the vibration plate. The drive unit is electrically connected to the vibration plate unit, and the drive unit is configured to: when a trigger condition is met, adjust a first driving frequency output to the piezoelectric sheet within a preset frequency range to obtain a plurality of corresponding first output currents, determine a target driving frequency based on the plurality of first output currents, and apply a driving voltage to the piezoelectric sheet based on the target driving frequency. According to the schemes provided in the embodiments of the present disclosure, in the embodiments, the vibration plate unit is formed by connecting a vibration plate and a piezoelectric sheet. When a trigger condition is met, the drive unit searches for a target driving frequency within a preset frequency range. A first driving frequency output to the piezoelectric sheet is continually changed within the given preset frequency range to obtain a plurality of first output currents corresponding to the first driving frequency, and then the target driving frequency is determined. The drive unit applies a driving voltage to the piezoelectric sheet based on the target driving frequency. The drive unit intelligently adjusts the target driving frequency output to the piezoelectric sheet, which can increase an amplitude of the vibration plate to increase a wind speed of the heat dissipation assembly, and greatly improve a heat dissipation capability.

## Claims

1. A heat dissipation assembly (100), comprising:
a vibration plate unit (200), provided with a vibration plate (210) and at least one piezoelectric sheet (220) connected to the vibration plate (210);
a drive unit (300), electrically connected to the vibration plate unit (200), and the drive unit (300) is configured to:
adjust, in response to meeting a trigger condition, a first driving frequency output to the piezoelectric sheet (220) within a preset frequency range to obtain a plurality of corresponding first output currents, determine a target driving frequency based on the plurality of first output currents, and apply a driving voltage to the piezoelectric sheet (220) based on the target driving frequency;
a fastening structure (400), wherein the vibration plate unit (200) is connected to the fastening structure (400), and the vibration plate (210) has one end connected to the fastening structure (400) and the other end overhanging; and
a plurality of vibration plate units (200) are provided and arranged in an array along a first direction and a second direction of the fastening structure (400).

2. The heat dissipation assembly (100) of claim 1, wherein determining a target driving frequency based on the plurality of first output currents comprises:
determining a current extremum based on the plurality of first output currents; and
determining a corresponding target driving frequency based on the current extremum.

3. The heat dissipation assembly (100) of claim 2, wherein the trigger condition comprises at least one of the following that:
the heat dissipation assembly (100) is started; or
a second output current of the drive unit (300) is detected when the heat dissipation assembly (100) operates continuously, and a difference between the second output current and the current extremum exceeds a preset difference range; or
a continuous operation time of the heat dissipation assembly (100) reaches a preset time period after the target driving frequency is determined each time.

4. The heat dissipation assembly (100) of claim 1, wherein the piezoelectric sheet (220) is arranged at an end of the vibration plate (210) connected to the fastening structure (400).

5. The heat dissipation assembly (100) of claim 1, wherein one side of the vibration plate (210) is provided with the piezoelectric sheet (220), or two sides of the vibration plate (210) are both provided with the piezoelectric sheet (220).

6. The heat dissipation assembly (100) of claim 1, wherein 2N vibration plate units (200) are provided and divided into two vibration plate arrays each comprising N vibration plate units (200), and the drive unit (300) is further configured to apply driving signals with opposite phases to vibration plate units (200) located in different arrays respectively, wherein N≥1.

7. The heat dissipation assembly (100) of claim 1, wherein 2N+1 vibration plate units (200) are provided and divided into two vibration plate arrays, the two vibration plate arrays respectively comprise N+1 vibration plate units (200) and N vibration plate units (200), and the drive unit (300) is further configured to apply driving signals with opposite phases to vibration plate units (200) located in different arrays respectively, wherein N≥1.

8. A heat dissipator (600), **characterized by** comprising the heat dissipation assembly (100) of any of claims 1 to 7.

9. The heat dissipator (600) of claim 8, wherein the heat dissipator (600) is provided with a base (610), and the heat dissipation assembly (100) is mounted on the heat dissipator along a normal direction of the base (610), or the heat dissipation assembly (100) is mounted on the heat dissipator (600) along a direction parallel to the base (610).

10. A control method for a heat dissipation assembly (100), the control method comprising:
providing a heat dissipation assembly according to claim 1;
adjusting, in response to meeting a trigger condition, a first driving frequency output to the piezoelectric sheet (220) within a preset frequency range to obtain a plurality of corresponding first output currents (S110);
determining a target driving frequency based on the plurality of first output currents (S120); and
applying a driving voltage to the piezoelectric sheet (220) based on the target driving frequency (S130).

11. The control method of claim 10, wherein determining a target driving frequency based on the plurality of first output currents (S120) comprises:
determining a current extremum based on the plurality of first output currents (S210); and
determining a corresponding target driving frequency based on the current extremum (S220).

12. The control method of claim 10, wherein 2N vibration plate units (200) are provided and divided into two vibration plate arrays (500) each comprising N vibration plate units (200), wherein N≥1, and the control method further comprises:
applying driving signals with opposite phases to vibration plate units (200) located in different arrays, respectively.

13. The control method of claim 10, wherein 2N+1 vibration plate units (200) are provided and divided into two vibration plate arrays (500), the two vibration plate arrays (500) respectively comprise N+1 vibration plate units (200) and N vibration plate units (200), wherein N≥1, and the control method further comprises:
applying driving signals with opposite phases to vibration plate units (200) located in different arrays, respectively.

## Patentansprüche

1. Wärmeableitungsanordnung (100), umfassend:
eine Schwingplatteneinheit (200), die mit einer Schwingplatte (210) und mindestens einer piezoelektrischen Schicht (220), die mit der Schwingplatte (210) verbunden ist, versehen ist;
eine Antriebseinheit (300), die elektrisch mit der Schwingplatteneinheit (200) verbunden ist, und wobei die Antriebseinheit (300) konfiguriert ist zum:
Anpassen, als Reaktion auf das Erfüllen einer Auslösebedingung, einer ersten Antriebsfrequenz, die an die piezoelektrische Schicht (220) ausgegeben wird, innerhalb eines voreingestellten Frequenzbereichs, um eine Vielzahl von entsprechenden ersten Ausgangsströmen zu erhalten, Bestimmen einer Zielantriebsfrequenz basierend auf der Vielzahl von ersten Ausgangsströmen und Anlegen einer Antriebsspannung an die piezoelektrische Schicht (220) basierend auf der Zielantriebsfrequenz;
eine Befestigungsstruktur (400), wobei die Schwingplatteneinheit (200) mit der Befestigungsstruktur (400) verbunden ist und die Schwingplatte (210) ein Ende aufweist, das mit der Befestigungsstruktur (400) verbunden ist, und das andere Ende überhängend ist; und
eine Vielzahl von Schwingplatteneinheiten (200) bereitgestellt und in einer Reihe entlang einer ersten Richtung und einer zweiten Richtung der Befestigungsstruktur (400) angeordnet sind.

2. Wärmeableitungsanordnung (100) nach Anspruch 1, wobei das Bestimmen einer Zielantriebsfrequenz basierend auf der Vielzahl von ersten Ausgangsströmen umfasst:
Bestimmen eines Stromextremwerts basierend auf der Vielzahl von ersten Ausgangsströmen; und
Bestimmen einer entsprechenden Zielantriebsfrequenz basierend auf dem Stromextremwert.

3. Wärmeableitungsanordnung (100) nach Anspruch 2, wobei die Auslösebedingung mindestens eines von Folgendem umfasst, dass:
die Wärmeableitungsanordnung (100) gestartet wird; oder
ein zweiter Ausgangsstrom der Antriebseinheit (300) erfasst wird, wenn die Wärmeableitungsanordnung (100) kontinuierlich arbeitet, und eine Differenz zwischen dem zweiten Ausgangsstrom und dem Stromextremwert einen voreingestellten Differenzbereich überschreitet; oder
eine kontinuierliche Betriebszeit der Wärmeableitungsanordnung (100) nach jedem Bestimmen der Zielantriebsfrequenz eine voreingestellte Zeitspanne erreicht.

4. Wärmeableitungsanordnung (100) nach Anspruch 1, wobei die piezoelektrische Schicht (220) an einem Ende der Schwingplatte (210) angeordnet ist, das mit der Befestigungsstruktur (400) verbunden ist.

5. Wärmeableitungsanordnung (100) nach Anspruch 1, wobei eine Seite der Schwingplatte (210) mit der piezoelektrischen Schicht (220) versehen ist oder zwei Seiten der Schwingplatte (210) beide mit der piezoelektrischen Schicht (220) versehen sind.

6. Wärmeableitungsanordnung (100) nach Anspruch 1, wobei 2N Schwingplatteneinheiten (200) bereitgestellt und in zwei Schwingplattenreihen unterteilt sind, die jeweils N Schwingplatteneinheiten (200) umfassen, und die Antriebseinheit (300) ferner konfiguriert ist, um Antriebssignale mit entgegengesetzten Phasen jeweils an Schwingplatteneinheiten (200) anzulegen, die sich in verschiedenen Reihen befinden, wobei N ≥ 1.

7. Wärmeableitungsanordnung (100) nach Anspruch 1, wobei 2N+1 Schwingplatteneinheiten (200) bereitgestellt und in zwei Schwingplattenreihen unterteilt sind, wobei die zwei Schwingplattenreihen jeweils N+1 Schwingplatteneinheiten (200) und N Schwingplatteneinheiten (200) umfassen, und die Antriebseinheit (300) ferner konfiguriert ist, um Antriebssignale mit entgegengesetzten Phasen jeweils an Schwingplatteneinheiten (200) anzulegen, die sich in verschiedenen Reihen befinden, wobei N ≥ 1.

8. Wärmeableiter (600), **dadurch gekennzeichnet, dass** er die Wärmeableitungsanordnung (100) nach einem der Ansprüche 1 bis 7 umfasst.

9. Wärmeableiter (600) nach Anspruch 8, wobei der Wärmeableiter (600) mit einer Basis (610) versehen ist und die Wärmeableitungsanordnung (100) am Wärmeableiter entlang einer Normalenrichtung der Basis (610) montiert ist oder die Wärmeableitungsanordnung (100) am Wärmeableiter (600) entlang einer Richtung parallel zur Basis (610) montiert ist.

10. Steuerungsverfahren für eine Wärmeableitungsanordnung (100), wobei das Steuerungsverfahren umfasst:
Bereitstellen einer Wärmeableitungsanordnung nach Anspruch 1;
Anpassen, als Reaktion auf das Erfüllen einer Auslösebedingung, einer ersten Antriebsfrequenz, die an die piezoelektrische Schicht (220) ausgegeben wird, innerhalb eines voreingestellten Frequenzbereichs, um eine Vielzahl von entsprechenden ersten Ausgangsströmen zu erhalten (S110);
Bestimmen einer Zielantriebsfrequenz basierend auf der Vielzahl von ersten Ausgangsströmen (S120); und
Anlegen einer Antriebsspannung an die piezoelektrische Schicht (220) basierend auf der Zielantriebsfrequenz (S130).

11. Steuerungsverfahren nach Anspruch 10, wobei das Bestimmen einer Zielantriebsfrequenz basierend auf der Vielzahl von ersten Ausgangsströmen (S120) umfasst:
Bestimmen eines Stromextremwerts basierend auf der Vielzahl von ersten Ausgangsströmen (S210); und
Bestimmen einer entsprechenden Zielantriebsfrequenz basierend auf dem Stromextremwert (S220).

12. Steuerungsverfahren nach Anspruch 10, wobei 2N Schwingplatteneinheiten (200) bereitgestellt und in zwei Schwingplattenreihen (500) unterteilt sind, die jeweils N Schwingplatteneinheiten (200) umfassen, wobei N ≥ 1, und das Steuerungsverfahren ferner umfasst:
Anlegen von Antriebssignalen mit entgegengesetzten Phasen jeweils an Schwingplatteneinheiten (200), die sich in verschiedenen Reihen befinden.

13. Steuerungsverfahren nach Anspruch 10, wobei 2N+1 Schwingplatteneinheiten (200) bereitgestellt und in zwei Schwingplattenreihen (500) unterteilt sind, wobei die zwei Schwingplattenreihen (500) jeweils N+1 Schwingplatteneinheiten (200) und N Schwingplatteneinheiten (200) umfassen, wobei N ≥ 1, und das Steuerungsverfahren ferner umfasst:
Anlegen von Antriebssignalen mit entgegengesetzten Phasen jeweils an Schwingplatteneinheiten (200), die sich in verschiedenen Reihen befinden.

## Revendications

1. Ensemble de dissipation thermique (100), comprenant :
une unité de plaque vibrante (200), pourvue d'une plaque vibrante (210) et d'au moins une feuille piézoélectrique (220) connectée à la plaque vibrante (210) ;
une unité d'entraînement (300), électriquement connectée à l'unité de plaque vibrante (200), et l'unité d'entraînement (300) est configurée pour :
ajuster, en réponse à la satisfaction d'une condition de déclenchement, une première fréquence d'entraînement délivrée en sortie à la feuille piézoélectrique (220) dans une plage de fréquences prédéfinie pour obtenir une pluralité de premiers courants de sortie correspondants, déterminer une fréquence d'entraînement cible sur la base de la pluralité de premiers courants de sortie, et appliquer une tension d'entraînement à la feuille piézoélectrique (220) sur la base de la fréquence d'entraînement cible ;
une structure de fixation (400), dans laquelle l'unité de plaque vibrante (200) est connectée à la structure de fixation (400), et la plaque vibrante (210) présente une extrémité connectée à la structure de fixation (400) et l'autre extrémité en porte-à-faux ; et
une pluralité d'unités de plaque de vibration (200) sont prévues et disposées en un réseau le long d'une première direction et d'une deuxième direction de la structure de fixation (400).

2. Ensemble de dissipation thermique (100) selon la revendication 1, dans lequel la détermination d'une fréquence d'entraînement cible sur la base de la pluralité de premiers courants de sortie comprend :
la détermination d'un extremum de courant sur la base de la pluralité de premiers courants de sortie ; et
la détermination d'une fréquence d'entraînement cible correspondante sur la base de l'extremum de courant.

3. Ensemble de dissipation thermique (100) selon la revendication 2, dans lequel la condition de déclenchement comprend au moins l'un des éléments suivants :
l'ensemble de dissipation thermique (100) est démarré ; ou
un deuxième courant de sortie de l'unité d'entraînement (300) est détecté lorsque l'ensemble de dissipation thermique (100) fonctionne en continu, et une différence entre le deuxième courant de sortie et l'extremum de courant dépasse une plage de différence prédéfinie ; ou
un temps de fonctionnement continu de l'ensemble de dissipation thermique (100) atteint une période de temps prédéfinie après que la fréquence d'entraînement cible est déterminée à chaque fois.

4. Ensemble de dissipation thermique (100) selon la revendication 1, dans lequel la feuille piézoélectrique (220) est disposée à une extrémité de la plaque vibrante (210) connectée à la structure de fixation (400).

5. Ensemble de dissipation thermique (100) selon la revendication 1, dans lequel un côté de la plaque vibrante (210) est pourvu de la feuille piézoélectrique (220), ou deux côtés de la plaque vibrante (210) sont tous deux pourvus de la feuille piézoélectrique (220).

6. Ensemble de dissipation thermique (100) selon la revendication 1, dans lequel 2N unités de plaques vibrantes (200) sont prévues et divisées en deux réseaux de plaques vibrantes comprenant chacun N unités de plaques vibrantes (200), et l'unité d'entraînement (300) est en outre configurée pour appliquer des signaux d'entraînement avec des phases opposées aux unités de plaques vibrantes (200) respectivement situées dans différents réseaux, où N≥1.

7. Ensemble de dissipation thermique (100) selon la revendication 1, dans lequel 2N+1 unités de plaques vibrantes (200) sont prévues et divisées en deux réseaux de plaques vibrantes, les deux réseaux de plaques vibrantes comprennent respectivement N+1 unités de plaques vibrantes (200) et N unités de plaques vibrantes (200), et l'unité d'entraînement (300) est en outre configurée pour appliquer des signaux d'entraînement avec des phases opposées aux unités de plaques vibrantes (200) respectivement situées dans différents réseaux, où N≥1.

8. Dissipateur thermique (600), **caractérisé en ce qu'**il comprend l'ensemble de dissipation thermique (100) selon l'une quelconque des revendications 1 à 7.

9. Dissipateur thermique (600) selon la revendication 8, dans lequel le dissipateur thermique (600) est pourvu d'une base (610), et l'ensemble de dissipation thermique (100) est monté sur le dissipateur thermique le long d'une direction normale de la base (610), ou l'ensemble de dissipation thermique (100) est monté sur le dissipateur thermique (600) le long d'une direction parallèle à la base (610).

10. Procédé de commande pour un ensemble de dissipation thermique (100), le procédé de commande comprenant :
la fourniture d'un ensemble de dissipation thermique selon la revendication 1 ;
l'ajustement, en réponse à la satisfaction d'une condition de déclenchement, d'une première fréquence d'entraînement délivrée en sortie à la feuille piézoélectrique (220) dans une plage de fréquences prédéfinie pour obtenir une pluralité de premiers courants de sortie correspondants (S110) ;
la détermination d'une fréquence d'entraînement cible sur la base de la pluralité de premiers courants de sortie (S120) ; et
l'application d'une tension d'entraînement à la feuille piézoélectrique (220) sur la base de la fréquence d'entraînement cible (S130).

11. Procédé de commande selon la revendication 10, dans lequel la détermination d'une fréquence d'entraînement cible sur la base de la pluralité de premiers courants de sortie (S120) comprend :
la détermination d'un extremum de courant sur la base de la pluralité de premiers courants de sortie (S210) ; et
la détermination d'une fréquence d'entraînement cible correspondante sur la base de l'extremum de courant (S220).

12. Procédé de commande selon la revendication 10, dans lequel 2N unités de plaques vibrantes (200) sont prévues et divisées en deux réseaux de plaques vibrantes (500) comprenant chacun N unités de plaques vibrantes (200), où N≥1, et le procédé de commande comprend en outre :
l'application de signaux d'entraînement présentant des phases opposées aux unités de plaques vibrantes (200) respectivement situées dans différents réseaux.

13. Procédé de commande selon la revendication 10, dans lequel 2N+1 unités de plaques vibrantes (200) sont prévues et divisées en deux réseaux de plaques vibrantes (500), les deux réseaux de plaques vibrantes (500) comprennent respectivement N+1 unités de plaques vibrantes (200) et N unités de plaques vibrantes (200), où N≥1, et le procédé de commande comprend en outre :
l'application de signaux d'entraînement présentant des phases opposées aux unités de plaques vibrantes (200) respectivement situées dans différents réseaux.
